(19) Europäisches Patentamt / European Patent Office / Office européen des brevets

(11) **EP 2 839 066 B1**

(12) **FASCICULE DE BREVET EUROPEEN**

(45) Date de publication et mention
de la délivrance du brevet:
**05.06.2019 Bulletin 2019/23**

(21) Numéro de dépôt: **13719994.9**

(22) Date de dépôt: **11.04.2013**

(51) Int Cl.:
*D06C 29/00* (2006.01)   *B29C 70/24* (2006.01)
*C04B 35/571* (2006.01)   *D03D 25/00* (2006.01)
*D06C 21/00* (2006.01)   *C23C 16/02* (2006.01)
*B32B 18/00* (2006.01)   *C04B 35/628* (2006.01)

(86) Numéro de dépôt international:
**PCT/FR2013/050790**

(87) Numéro de publication internationale:
**WO 2013/156712 (24.10.2013 Gazette 2013/43)**

(54) **PROCÉDÉ DE FABRICATION D'UNE PIÈCE EN MATÉRIAU COMPOSITE AVEC AMÉLIORATION DE LA DENSIFICATION INTRA-FILS**

VERFAHREN ZUR HERSTELLUNG EINES BAUTEILS AUS EINEM VERBUNDWERKSTOFF MIT VERBESSERTER ZWISCHENFASERVERDICHTUNG

METHOD FOR MANUFACTURING A COMPONENT MADE OF COMPOSITE WITH IMPROVED INTRA-FILAMENT DENSIFICATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.04.2012 FR 1253520**

(43) Date de publication de la demande:
**25.02.2015 Bulletin 2015/09**

(73) Titulaire: **Safran Ceramics**
**33185 Le Haillan (FR)**

(72) Inventeurs:
• **FILLION, Arnaud**
**F-33290 Blanquefort (FR)**

• **PHILIPPE, Eric**
**F-33700 Merignac (FR)**
• **CHARLEUX, François**
**F-33000 Bordeaux (FR)**
• **BOUILLON, Eric**
**F-33185 Le Haillan (FR)**

(74) Mandataire: **Desormiere, Pierre-Louis et al**
**Cabinet Beau de Loménie**
**158, rue de l'Université**
**75340 Paris Cedex 07 (FR)**

(56) Documents cités:
**EP-A2- 0 207 422     WO-A1-00/75410**
**FR-A1- 2 952 052     US-A- 5 217 796**
**US-A- 5 557 831**

**Description**

Arrière-plan de l'invention

La présente invention concerne un procédé de fabrication d'une pièce en matériau composite comportant un renfort fibreux densifié par une matrice.

Le domaine d'application de l'invention concerne les matériaux composites thermostructuraux, c'est-à-dire des matériaux composites ayant des bonnes propriétés mécaniques et une capacité à conserver ces propriétés à température élevée. Des matériaux composites thermostructuraux typiques sont les matériaux composites carbone/carbone (C/C) formés d'un renfort en fibres de carbone densifié par une matrice en carbone et les matériaux composites à matrice céramique (CMC) formés d'un renfort en fibres réfractaires (carbone ou céramique) densifié par une matrice au moins partiellement céramique. Des exemples de CMC sont les composites C/SiC (renfort en fibres de carbone et matrice en carbure de silicium), les composites C/C-SiC (renfort en fibres de carbone et matrice comprenant une phase carbone, généralement au plus près des fibres, et une phase carbure de silicium) et les composites SiC/SiC (fibres de renfort et matrice en carbure de silicium). Une couche d'interphase peut être interposée entre les fibres de renfort et la matrice pour améliorer la tenue mécanique du matériau.

La fabrication d'une pièce en matériau composite thermostructural comprend généralement la réalisation d'une préforme fibreuse dont la forme est voisine de celle de la pièce à fabriquer et la densification de la préforme par la matrice. FR 2 952 052 décrit, en particulier, la réalisation d'un composite thermostructural.

La préforme fibreuse constitue le renfort de la pièce dont le rôle est essentiel vis-à-vis des propriétés mécaniques. La préforme est obtenue à partir de textures fibreuses : fils, câbles, tresses, tissus, feutres... La mise en forme est réalisée par bobinage, tissage, empilage, et éventuellement aiguilletage de strates bidimensionnelles de tissu ou de nappes de câbles...

La densification de la préforme fibreuse consiste à combler la porosité de la préforme, dans tout ou partie du volume de celle-ci, par le matériau constitutif de la matrice.

La matrice d'un matériau composite peut être obtenue suivant différents procédés connus et notamment suivant le procédé par voie liquide et le procédé par voie gazeuse.

Le procédé par voie liquide consiste à imprégner la préforme par une composition liquide contenant un précurseur organique du matériau de la matrice. Le précurseur organique se présente habituellement sous forme d'un polymère, tel qu'une résine, éventuellement dilué dans un solvant. La transformation du précurseur en phase réfractaire est réalisée par traitement thermique, après élimination du solvant éventuel et réticulation du polymère. Le traitement thermique consiste à pyrolyser le précurseur organique pour transformer la matrice organique en une matrice carbone ou céramique selon le précurseur utilisé et les conditions de pyrolyse. A titre d'exemple, des précurseurs liquides de carbone peuvent être des résines à taux de coke relativement élevé, telles que des résines phénoliques, tandis que des précurseurs liquides de céramique, notamment de SiC, peuvent être des résines de type polycarbosilane (PCS), polysiloxane (PSX), polytitanocarbosilane (PTCS), ou polysilazane (PSZ). Plusieurs cycles consécutifs, depuis l'imprégnation jusqu'au traitement thermique, peuvent être réalisés pour parvenir au degré de densification souhaité.

Le procédé par voie gazeuse consiste dans l'infiltration chimique en phase vapeur. La préforme fibreuse est placée dans un four dans lequel est admise une phase gazeuse réactionnelle. La pression et la température régnant dans le four et la composition de la phase gazeuse sont choisies de manière à permettre la diffusion de la phase gazeuse au sein de la porosité de la préforme pour y former la matrice par dépôt, au contact des fibres, d'un matériau solide résultant d'une décomposition d'un constituant de la phase gazeuse ou d'une réaction entre plusieurs constituants. A titre d'exemple, des précurseurs gazeux du carbone peuvent être des hydrocarbures donnant le carbone par craquage, tel que le méthane, et un précurseur gazeux de céramique, notamment de SiC, peut-être du méthyltrichlorosilane (MTS) donnant du SiC par décomposition du MTS (éventuellement en présence d'hydrogène).

Afin d'obtenir une densification homogène et optimale de la préforme fibreuse et conférer ainsi de bonnes propriétés mécaniques à la pièce, la matrice doit être déposée non seulement dans la porosité présente entre les fils de la préforme (porosité ou espaces inter-fils) mais aussi dans la porosité présente à l'intérieur des fils, c'est-à-dire la porosité entre les filaments d'un même fil (porosité ou espaces intra-fil).

Cependant, la densification à coeur d'un fil continu, par voie liquide ou gazeuse, est souvent difficile à réaliser en raison d'une distance moyenne entre les fibres des fils trop faibles et, par conséquent, d'une porosité intra-fil insuffisante et difficile d'accès depuis l'extérieur des fils, en particulier lorsque la texture est réalisée par tissage. Dans certains cas, une trop faible quantité de matrice à l'intérieur des fils peut conduire à une diminution des propriétés mécaniques et de la tenue à la fatigue sous contrainte haute température du matériau.

Le document US 5 217 796 décrit la réalisation de cartes pour circuits imprimés à partir d'une texture fibreuse constituée de fibres inorganiques, par exemple des fibres de verre, la texture étant renforcée par une résine. Dans ce document, la texture est soumise à des jets d'eau sous pression afin d'ouvrir les fils exposés en surface de la texture. Cependant, dans ce document, seuls les fils en surface sont traités et la pression des jets d'eau est réglée de manière à casser ou couper les fils en surface, ce qui ne peut être envisagé dans le cas de la fabrication d'une pièce en matériau composite structural ou thermostructural car l'intégrité et la continuité des fils doivent être préservées en tout point de la texture afin de ne pas altérer les propriétés mécaniques de la pièce. En outre, la méthode décrite dans le document US 5 217 796 entraîne un foisonnement important à la surface de la texture qui est pénalisant pour l'infiltration à coeur de cette dernière lors d'une densification par infiltration chimique en phase vapeur. En effet, dans ce cas, la matrice se dépose principalement sur la surface foisonnante de la texture, ce qui conduit à une étanchéification rapide de la surface de la texture qui empêche la phase gazeuse de pénétrer à coeur de celle-ci. L'absence ou la présence réduite de matrice à coeur de la texture ne permet pas d'obtenir des pièces en matériau composite ayant des propriétés mécaniques satisfaisantes.

Objet et résumé de l'invention

La présente invention a pour but de remédier aux inconvénients précités et de proposer une solution qui permet de faciliter et d'améliorer la densification intra-fils par une matrice dans une texture fibreuse tissée.

A cet effet, l'invention propose un procédé selon la revendication 1.

En réduisant le taux moyen de fibres dans la texture fibreuse par rapport au taux moyen initial de fibres présenté par celle-ci après tissage, on augmente la distance moyenne entre les fibres des fils. En effet, en traitant la texture avant densification avec un fluide sous pression, on fait foisonner les fils de la texture. On augmente ainsi le nombre et le volume des porosités présentes dans les fils (porosité intra-fils), ce qui favorise la densification à coeur des fils et améliore les propriétés mécaniques et la durée de vie du matériau obtenu.

La réduction du taux de fibres dans la texture par traitement de celle-ci avec un fluide sous pression est réalisée de manière à obtenir une texture fibreuse dont le taux moyen final de fibres est compris entre 20% et 45%, ce qui permet d'ouvrir les fils d'une manière significative pour améliorer leur infiltration à coeur sans déstructurer la texture fibreuse.

En outre, en limitant la pression de sortie des jets d'eau à 100 bars pour une distance minimale de 50 mm, on assure l'ouverture des fils de la texture sans rupture des fils présents en surface. La préservation de la continuité des fils en surface permet d'obtenir un renfort fibreux pour une pièce en matériau composite qui est apte à transmettre les efforts de manière identique dans toute son épaisseur, ce qui n'est pas le cas lorsque les fils sont rompus en surface.

Selon un aspect de l'invention, la texture fibreuse est une texture multicouche réalisée par tissage tridimensionnel de fils continus de fibres de carbone, de carbure de silicium ou d'oxyde.

La densification de la texture fibreuse peut être réalisée par infiltration chimique en voie gazeuse d'une matrice dans ladite texture, ou par infiltration en voie liquide d'une matrice, ou encore en combinant une infiltration en voie liquide d'une matrice et une infiltration chimique en voie gazeuse d'une matrice dans ladite texture. Avant la densification, une couche d'interphase peut être déposée sur les fibres de la texture fibreuse.

Selon un autre aspect de l'invention, la matrice est une matrice céramique choisie parmi au moins : un oxyde, un nitrure, un carbure et un siliciure. La matrice céramique peut notamment comprendre au moins du carbure de silicium et du bore ou un de ses composés.

Selon encore un autre aspect de l'invention, le procédé comprend en outre une étape de mise en forme et consolidation de la texture fibreuse réalisée après l'étape de traitement de la texture avec un fluide sous pression et avant l'étape de densification de ladite texture.

Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :

- la figure 1 est une vue schématique d'une installation de traitement aux jets d'eau sous pression d'une texture fibreuse conformément à l'invention,
- la figure 2 est un ordinogramme illustrant des étapes successives d'un mode de mise en oeuvre d'un procédé conforme à l'invention,
- les figures 3 et 4 sont des microphotographies montrant un matériau composite obtenu suivant respectivement un procédé de fabrication de l'art antérieur et un procédé de fabrication de l'invention.

Description détaillée de modes de réalisation

La présente invention propose une méthode de fabrication d'une pièce en matériau composite thermostructural réalisée à partir d'une texture fibreuse obtenue par tissage de fils continus. Afin d'améliorer la densification intra-fils et, par conséquent, les propriétés mécaniques de la pièce, la texture est soumise à un ou plusieurs jets d'eau sous pression avant densification, ce qui permet de faire foisonner les fils de la texture tissée et d'augmenter la distance moyenne entre les fibres des fils. Ce traitement revient ainsi à augmenter l'épaisseur de la texture et à réduire le taux moyen de fibres dans la texture.

Conformément à l'invention, le traitement par jet(s) d'eau sous pression est réalisé de manière, d'une part, à réduire le taux moyen de fibres dans la texture par rapport au taux moyen initial et, d'autre part, d'obtenir un taux moyen final de fibres dans la texture d'une valeur comprise entre 20% et 45%. Pour des textures présentant un taux moyen initial de fibres supérieur à 30%, le traitement par un fluide sous pression correspond à réduire ce taux initial à une valeur inférieure.

A titre d'exemple, pour un taux moyen initial de fibres de 40%, le traitement par fluide sous pression est réalisé pour réduire ce taux à une valeur inférieure à 40% comme par exemple entre 20% et 35%.

Pour des textures présentant un taux moyen initial de fibres supérieur à 40%, le traitement par un fluide sous pression correspond à réduire ce taux initial à une valeur inférieure de manière à ramener ce taux à une valeur comprise entre 20% et 45%.

En outre, toujours conformément à la présente invention, la pression des jets d'eau en sortie de buse est au maximum de 100 bars, la ou les buses étant placées au minimum à une distance de 50 mm de la surface exposée de la texture à traiter. Ces conditions opératoires permettent d'assurer une ouverture des fils de la texture sans rompre ou casser les fils présents à la surface de la texture. La préservation de la continuité des fils en surface de texture permet d'obtenir une pièce en matériau composite qui présente de bonnes caractéristiques mécaniques sur toute l'épaisseur de son renfort fibreux constitué par la texture traitée.

Le procédé de fabrication d'une pièce en matériau composite débute par la réalisation d'une texture fibreuse obtenue par tissage tridimensionnel entre des fils de chaîne et des fils de trame. Par "tissage tridimensionnel" ou "tissage 3D", on entend ici un mode de tissage par lequel certains au moins des fils de chaîne lient des fils de trame sur plusieurs couches de trame. Parmi les tissages tridimensionnels qui peuvent être utilisés pour réaliser la texture fibreuse dans la présente invention, on citera notamment le tissage interlock et le tissage multicouches. Par "tissage interlock", on entend ici une armure de tissage 3D dont chaque couche de chaîne lie plusieurs couches de trames avec tous les fils de la même colonne de chaîne ayant le même mouvement dans le plan de l'armure. Un exemple de texture obtenue par tissage interlock est une texture ou préforme Guipex®. Par "tissage multicouches", on désigne ici un tissage 3D avec plusieurs couches de trame dont l'armure de base de chaque couche est équivalente à une armure de tissu 2D classique, tel qu'une armure de type toile (tissu multi-toile), satin ou sergé (tissu multi-satin ou multi-sergé), mais avec certains points de l'armure qui lient les couches de trame entre elles.

Des exemples détaillés de réalisation d'une texture ou préforme fibreuse par tissage 3D sont notamment décrits en détail dans les documents US 7 101 154, US 7 241 112, WO 2010/061140 et WO 2006/136755.

Les fils utilisés pour réaliser la texture fibreuse peuvent être en fibres de diverses natures, en particulier des fibres de carbone, de céramique (par exemple carbure de silicium) ou d'oxyde.

Après le tissage de la texture fibreuse et conformément à la présente invention, la texture fibreuse est soumise à un ou plusieurs jets d'eau sous pression afin de réduire le taux de fibres dans la texture.

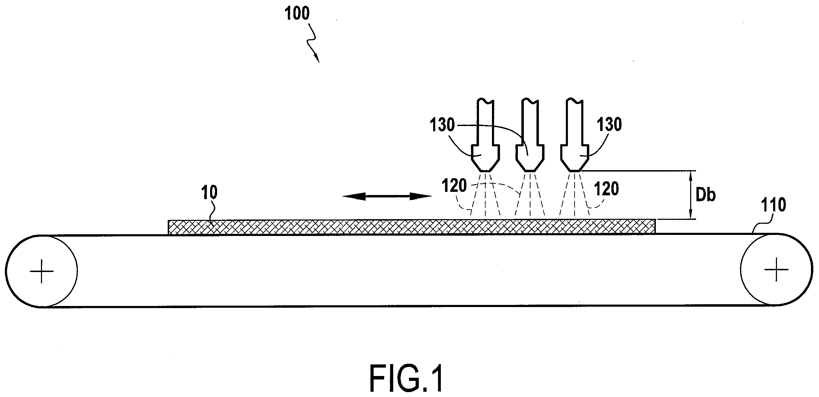

La figure 1 illustre une installation 100 permettant de réaliser un tel traitement. L'installation 100 comprend un tapis 110 sur lequel est disposée une texture fibreuse 10 destinée à être soumise à des jets d'eau sous pression 120 délivrés par des buses 130 positionnées sur le trajet du tapis 110. Lors du fonctionnement de l'installation, la texture fibreuse peut passer une ou plusieurs fois sous les jets d'eau sous pression 120. La texture peut être orientée différemment à chaque passage afin d'homogénéiser l'effet des jets d'eau sur l'ensemble des fils de la texture. Elle peut, par exemple, être tournée de 45° ou 90° avant chaque nouveau passage. La texture peut être également retournée après un ou plusieurs passage sous les jets d'eau sous pression 120 afin de soumettre les deux faces de celle-ci aux jets d'eau sous pression. Cela peut permettre notamment d'atteindre toutes les couches de fils dans le cas d'une texture épaisse.

La pression du jet d'eau en sortie de buse est réglée de manière à réduire le taux de fibres dans la texture à une valeur comprise entre 20% et 45% comme expliqué ci-avant. La pression à ajuster dépend principalement de l'épaisseur de la texture fibreuse à traiter et de la distance $D_b$ entre les buses 130 et la texture 10. Dans une moindre mesure, la pression est également réglée en fonction de la forme du jet en sortie de buse. Par exemple, la pression sera réglée plus fortement pour un jet très dispersé en sortie de buse que pour un jet plus concentré en sortie de buse.

A titre d'exemple, pour une texture fibreuse tissée 3D, telle qu'une texture Guipex®, ayant une épaisseur comprise entre 1 mm et 2 mm et étant traitée aux jets d'eau sous pression dans une installation PERFOJET JETLACE 3000 dans laquelle les buses sont situées à une distance de 50 mm de la face exposée de la texture fibreuse, la pression de jet d'eau en sortie de buse est ajustée à environ 80 bars.

En outre de l'étape de réalisation d'une texture fibreuse et de son traitement avec un fluide sous pression comme décrits ci-avant, le procédé de fabrication d'une pièce en matériau composite conforme à l'invention comprend les étapes bien connues de mise en forme et consolidation de la texture par voie liquide, pour obtenir une préforme consolidée, et densification de la préforme par voie gazeuse et/ou voie liquide.

Avant les étapes de consolidation et de densification, une étape de dépôt d'une couche d'interphase comme décrit dans les documents US 4 752 503 et US 5 486 379 peut être éventuellement réalisée.

La consolidation par voie liquide est, de façon bien connue en soi, réalisée par imprégnation de la texture fibreuse par un précurseur organique du matériau désiré pour la première phase de matrice assurant la consolidation. Il peut s'agir de précurseurs de céramique tels que les polycarbosilanes (PCS), polysiloxanes (PSX), polytitanocarbosilanes (PTCS), ou polysilazanes (PSZ), ou de précurseurs de carbone (résine phénolique, résine furanique, du brai, etc.).

La mise en forme de la texture fibreuse est réalisée généralement par moulage avant ou après l'imprégnation de la texture fibreuse avec la composition de consolidation. La texture fibreuse imprégnée est polymérisée, généralement à une température inférieure à 400 °C. A ce stade, la texture mise en forme est soumise à un traitement thermique pour transformer le précurseur par pyrolyse. Ce dernier traitement est réalisé à une température généralement comprise entre 500 °C et 2 800 °C, selon la nature du précurseur, la texture étant éventuellement maintenue dans le moule pour éviter des déformations.

La densification par voie gazeuse est réalisée par infiltration chimique en phase vapeur dans un four d'infiltration dans lequel est admise une phase gazeuse contenant généralement des précurseurs gazeux de céramique, notamment de carbure de silicium (SiC), ou de carbone. Les techniques de formation de matrices par voie gazeuse sont bien connues.

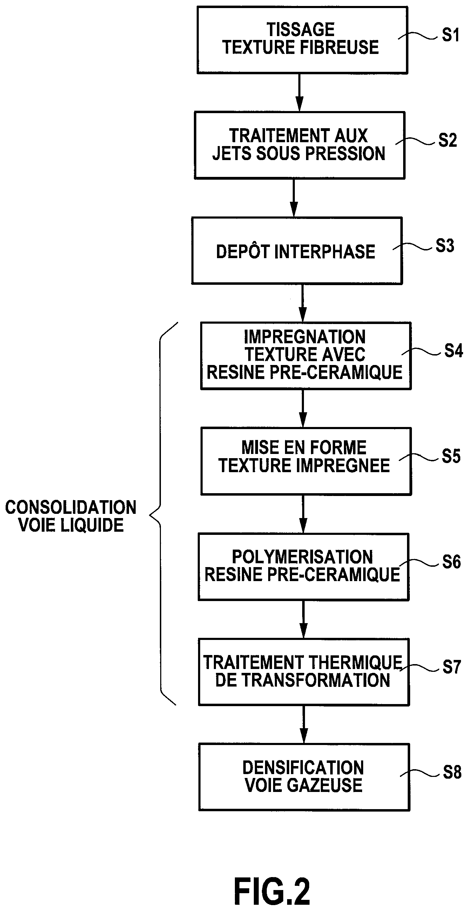

En référence à la figure 2, on décrit un mode de mise en oeuvre d'un procédé pour la fabrication d'une pièce en matériau composite thermostructural conforme à l'invention dans lequel la texture fibreuse, après sa réalisation par tissage et avant sa consolidation et sa densification, est soumise à un ou plusieurs jets d'eau sous pression.

La première étape (étape S1) consiste à tisser une texture fibreuse par tissage 3D de fils de fibres en céramique, par exemple des fils de fibre SiC de type ZMI® ou Nicalon®.

On procède ensuite à l'étape de traitement de la texture fibreuse par jet(s) d'eau sous pression, comme décrit ci-avant, c'est-à-dire dans des conditions opératoires permettant de réduire le taux de fibres dans la texture à une valeur comprise entre 20% et 45% et de favoriser ainsi l'infiltration des fils par la matrice déposée ultérieurement (étape S2).

Dans l'exemple décrit ici, une couche d'interphase est déposée sur les fibres de la texture fibreuse afin d'améliorer la tenue mécanique du matériau (étape S3).

La texture fibreuse est ensuite imprégnée avec une composition liquide de consolidation, ici une résine précurseur de carbure de silicium éventuellement diluée dans un solvant, par exemple de l'acétone (étape S4). Après les étapes éventuelles d'évaporation du solvant et de pré-polymérisation (pré-poussage), la texture fibreuse imprégnée est mise en forme par moulage (étape S5) et la résine est polymérisée (étape S6). La texture est alors soumise à un traitement thermique pour transformer la résine par pyrolyse en résidus solides de SiC qui permettent de consolider la texture et d'obtenir une préforme fibreuse qui se tient (préforme autoporteuse) (étape S7).

A ce stade du procédé, la préforme est suffisamment rigide pour être placée dans un four de densification par infiltration chimique en phase vapeur (CVI) sans recourir à des outillages (étape S8). Suivant la nature de la phase gazeuse introduite dans le four, une matrice céramique ou carbone est formée au sein de la texture fibreuse. La porosité interne des fils ayant été ouverte par le traitement au fluide sous pression, la phase gazeuse pénètre à la fois dans les espaces inter-fils et dans la porosité des fils, ce qui permet de former une matrice par voie gazeuse aussi bien en dehors qu'à l'intérieur des fils de la préforme.

Les propriétés thermomécaniques de la pièce en matériau composite ainsi réalisée sont supérieures à celles d'une pièce réalisée de façon similaire mais sans soumettre préalablement la texture fibreuse à des jets d'eau sous pression.

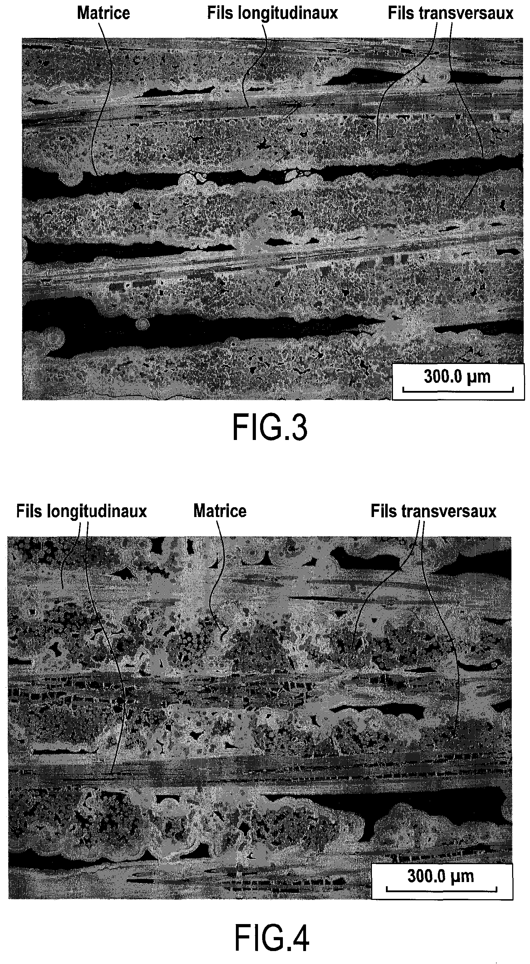

La figure 3 montre un matériau CMC après densification voie gazeuse d'une texture fibreuse en fibres SiC n'ayant pas été soumise, avant densification, à des jets d'eau sous pression tandis que la figure 4 montre un matériau CMC après densification voie gazeuse d'une texture fibreuse ayant été soumise à des jets d'eau sous pression conformément à l'invention.

Le matériau composite des figures 3 et 4 est un matériau CMC réalisé dans les conditions suivantes:

- formation texture fibreuse correspondant à un tissu Guipex® de 1 mm d'épaisseur par réalisation d'une structure multicouche de tissage tridimensionnel de fils de fibres SiC ZMI®,
- dépôt d'une interphase,
- consolidation voie liquide par imprégnation de la texture dans un bain de résine pré-céramique, polymérisation et pyrolyse de la résine,
- densification voie gazeuse (CVI) par une matrice SiC.

Pour le matériau de la figure 3, chacune des deux faces de la texture fibreuse est en outre préalablement soumise à deux passages sous des jets d'eau sous pression dans une installation PERFOJET JETLACE 3000 la pression des jets d'eau étant de 80 bars avec des buses situées à une distance de 50 mm de la surface exposée de la texture. Les jets d'eau sous pression sont ici délivrés par des buses comportant chacune 15 trous ayant chacun un diamètre de sortie de 0,127 mm.

Sur la figure 4 (microphotographie du matériau obtenu avec texture traitée aux jets d'eau sous pression), on observe le foisonnement/ouverture des fils de la texture et la présence de matrice à la fois dans les espaces intra-fils et inter-fils ainsi créés alors que sur la figure 3 (microphotographie du matériau obtenu avec texture non traitée aux jets d'eau sous pression), on n'observe pas de foisonnement/ouverture des fils de la texture, la matrice étant essentiellement localisée à l'extérieur des fils, c'est-à-dire dans les espaces inter-fils.

En outre, en comparant le matériau des figures 3 et 4, on constate une répartition plus homogène des fibres pour une texture ayant été préalablement traitée aux jets d'eau sous pression (figure 4) que non (figure 3). En effet, en réduisant le taux de fibres pour un volume donné avec un fluide sous pression, on fait foisonner les fils de la texture et on répartis les fibres dans des espaces inter-fils qui n'étaient pas couverts par les fils à l'origine.

Le tableau I ci-après indique les résultats de réduction du taux de fibres obtenu après un traitement d'une texture fibreuse (tissu Guipex®) aux jets d'eau dans la même installation que celle utilisée pour traiter les textures du matériau de la figure 4, la texture ayant été soumise à un jet d'eau sous pression avec une pression déterminée et sur une ou deux faces consécutivement comme indiqués dans la deuxième colonne du tableau.

Tableau I

| Fibre | Pression jet d'eau (bars) | Taux de fibres (%) initial | Epaisseur initiale texture (mm à 5 kPa) | taux de fibres (%) après traitement au jet d'eau | Epaisseur texture (mm à 5 kPa) après traitement au jet d'eau |
|---|---|---|---|---|---|
| ZMI® | 30 (1 face) | 57,6 | 1,075 | 53,6 | 1,16 |
| | 30 (1 face) | 57,6 | 1,075 | 53,6 | 1,16 |
| | 80 (2 faces) | 57,6 | 1,075 | 34,5 | 1,22 |
| | 80 (2 faces) | 57,6 | 1,075 | 34,5 | 1,45 |
| | 80 (2 faces) | 57,6 | 1,075 | 34,5 | 1,51 |
| | 30 à 120 (1 face) | 57,6 | 1,075 | 27,7 | 1,79 |
| | 30 à 120 (1 face) | 57,6 | 1,075 | 27,7 | 1,52 |

Dans le tableau ci-dessus, les textures fibreuses réalisées à partir de fibres ZMI® présentent une masse surfacique de 955 g/m$^2$. Certaines textures ont été testées plusieurs fois dans les mêmes conditions de traitement afin de démontrer la reproductibilité du procédé de l'invention.

Le taux de fibres dans la texture fibreuse (initial et après traitement au jet d'eau) est calculé à partir de la masse surfacique de la texture, de la densité ou masse volumique de fibres et de l'épaisseur de la texture suivant la formule suivante :

$$\text{Taux de fibre} = \text{masse surfacique}/(\text{densité fibres} \times \text{épaisseur texture})$$

Des essais comparatifs de durées de vie ont été réalisés entre deux éprouvettes réalisées en matériau composite CMC à partir de textures fibreuses tissées Guipex® identiques (même armure de tissage et même épaisseur), consolidées par voie liquide (CVL) avec une résine pré-céramique et densifiées par voie gazeuse (CVI). La texture fibreuse de la première éprouvette est réalisée avec des fibres SiC de type ZMI® et n'a pas été traitée aux jets d'eau sous pression avant densification. La texture fibreuse de la deuxième éprouvette est également réalisée avec des fibres SiC de type ZMI® mais a été soumise, avant consolidation et densification, à des jets d'eau à une pression de 80 bars sur ses deux faces consécutivement. Les deux éprouvettes ont été évaluées en fluage dans les mêmes conditions, à savoir à une température de 450°C et sous une charge de 2640 N. La durée de vie de la première éprouvette (sans traitement préalable de la texture fibreuse aux jets d'eau) est de 310 heures tandis que la durée de vie de la deuxième éprouvette (texture fibreuse traitée aux jets d'eau) est de 520 heures, ce qui montre l'influence positive du traitement aux jets d'eau sous pression sur la durée de vie du matériau.

L'homme du métier adaptera les conditions opératoires, en particulier la pression du ou des jets d'eau, en fonction de la nature de celui-ci et des autres paramètres décrits ci-avant (distance entre buse(s) et texture, épaisseur texture, etc.). L'adaptation des conditions opératoires pourra notamment être effectuée après plusieurs essais jusqu'à obtenir la réduction désirée du taux de fibres dans la texture, c'est-à-dire conformément à l'invention, une réduction du taux moyen initial de fibres dans la texture à une valeur comprise entre 20% et 45%.

**Revendications**

1. Procédé de fabrication d'une pièce en matériau composite thermostructural comprenant un renfort fibreux densifié par une matrice, ledit procédé comprenant les étapes suivantes :

   - réalisation d'une texture fibreuse (10) par tissage tridimensionnel entre des fils de chaîne et des fils de trame, ladite texture fibreuse présentant un taux moyen initial de fibres déterminé,
   - densification de la texture fibreuse par une matrice, **caractérisé en ce qu'**il comprend, avant la densification de la texture fibreuse (10), une étape de traitement de la texture consistant à soumettre ladite texture à un ou plusieurs jets d'eau sous pression (120) de manière à augmenter l'épaisseur de la texture et à réduire le taux moyen de fibres dans la texture à une valeur comprise entre 20% et 45% et **en ce que** chaque jet d'eau est délivré à partir d'une buse, la pression du jet d'eau en sortie de buse étant inférieure ou égale à 100 bars, chaque buse étant placée à une distance supérieure ou égale à 50 mm de la surface de la texture fibreuse.

2. Procédé selon la revendication 1, **caractérisé en ce que** la texture fibreuse (10) est une texture multicouche réalisée par tissage tridimensionnel de fils continus de fibres de carbone, de carbure de silicium ou d'oxyde.

3. Procédé selon la revendication 1 ou 2, **caractérisé en ce qu'**il comprend, avant la densification de la texture fibreuse, le dépôt d'une interphase sur les fibres de ladite texture fibreuse.

4. Procédé selon l'une quelconque des revendications 1 à 3, **caractérisé en ce que** la densification de la texture fibreuse comprend l'infiltration chimique en voie gazeuse d'une matrice dans ladite texture.

5. Procédé selon l'une quelconque des revendications 1 à 4, **caractérisé en ce que** la densification de la texture fibreuse comprend l'infiltration en voie liquide d'une matrice dans ladite texture.

6. Procédé selon la revendication 4 ou 5, **caractérisé en ce que** la matrice est une matrice céramique choisie parmi au moins : un oxyde, un nitrure, un carbure et un siliciure.

7. Procédé selon la revendication 6, **caractérisé en ce que** la matrice céramique comprend au moins du carbure de silicium et du bore ou un de ses composés.

8. Procédé selon l'une quelconque des revendications 1 à 7, **caractérisé en ce qu'**il comprend en outre une étape de mise en forme et consolidation de la texture fibreuse réalisée après l'étape de traitement de la texture avec un fluide sous pression et avant l'étape de densification de ladite texture.

**Patentansprüche**

1. Verfahren zur Herstellung eines Bauteils aus einem thermostrukturellen Verbundwerkstoff, umfassend eine durch eine Matrix verdichtete Faserverstärkung, wobei das Verfahren die folgenden Schritte umfasst:

   - Realisierung einer Fasertextur (10) durch dreidimensionales Weben zwischen den Kettfäden und den Schussfäden, wobei die Fasertextur einen bestimmten ursprünglichen mittleren Fasergehalt aufweist,
   - Verdichtung der Fasertextur durch eine Matrix,

   **dadurch gekennzeichnet, dass** es vor der Verdichtung der Fasertextur (10) einen Schritt der Behandlung der Textur umfasst, der daraus besteht, die Textur einem oder mehreren druckbeaufschlagten Wasserstrahlen (120) zu unterwerfen, um die Dicke der Textur zu erhöhen und um den mittleren Fasergehalt in der Textur auf einen Wert zwischen 20 % und 45 % zu erhöhen und dadurch, dass jeder Wasserstrahl durch eine Düse zugeführt wird, wobei der Druck des Wasserstrahls beim Verlassen der Düse kleiner gleich 100 bar ist, wobei jede Düse in einem Abstand größer gleich 50 mm von der Oberfläche der Fasertextur platziert ist.

2. Verfahren nach Anspruch 1, **dadurch gekennzeichnet, dass** die Fasertextur (10) eine mehrschichtige Textur ist, die durch dreidimensionales Weben von Endlosfäden von Kohlenstoff-, Siliciumcarbid- oder Oxidfasern umgesetzt wird.

3. Verfahren nach Anspruch 1 oder 2, **dadurch gekennzeichnet, dass** es vor der Verdichtung der Fasertextur die Ablagerung einer Zwischenphase auf den Fasern der Fasertextur umfasst.

**4.** Verfahren nach einem der Ansprüche 1 bis 3, **dadurch gekennzeichnet, dass** die Verdichtung der Fasertextur das chemische Eindringen einer Matrix in die Textur über die Gasphase umfasst.

**5.** Verfahren nach einem der Ansprüche 1 bis 4, **dadurch gekennzeichnet, dass** die Verdichtung der Fasertextur das Eindringen einer Matrix in die Textur über die Flüssigphase umfasst.

**6.** Verfahren nach Anspruch 4 oder 5, **dadurch gekennzeichnet, dass** die Matrix eine Keramikmatrix ist, ausgewählt aus mindestens einem von: einem Oxid, einem Nitrid, einem Carbid und einem Silicid.

**7.** Verfahren nach Anspruch 6, **dadurch gekennzeichnet, dass** die Keramikmatrix zumindest Silicium- und Borcarbid oder eine seiner Verbindungen umfasst.

**8.** Verfahren nach einem der Ansprüche 1 bis 7, **dadurch gekennzeichnet, dass** es ferner einen Schritt des Formens und der Verfestigung der Fasertextur umfasst, der nach dem Schritt der Behandlung der Textur mit einem druckbeaufschlagten Fluid und vor dem Schritt der Verdichtung der Textur umgesetzt wird.

**Claims**

**1.** A method of fabricating a thermostructural composite material part comprising fiber reinforcement densified by a matrix, said method comprising the following steps:

• making a fiber fabric (10) by three-dimensional weaving of warp and weft yarns, said fiber fabric presenting a determined initial mean fiber percentage; and
• densifying the fiber fabric with a matrix;

the method being **characterized in that** it comprises, prior to densifying the fiber fabric (10), a step of treating the fabric by subjecting said fabric to one or more jets of water under pressure (120) so as to increase the thickness of the fabric and reduce the mean fiber percentage in the fabric to a value lying in the range 20% to 45%, and **in that** each water jet is delivered from a nozzle, the pressure of the water jet at the outlet from the nozzle being less than or equal to 100 bars, each nozzle being placed at a distance from the surface of the fiber fabric that is greater than or equal to 50 mm.

**2.** A method according to claim 1, **characterized in that** the fiber fabric (10) is a multilayer fabric made by three-dimensional weaving of continuous yarns of carbon fibers, of silicon carbide fibers, or of oxide fibers.

**3.** A method according to claim 1 or claim 2, **characterized in that** it comprises, prior to densifying the fiber fabric, depositing an interphase on the fibers of said fiber fabric.

**4.** A method according to any one of claims 1 to 3, **characterized in that** densification of the fiber fabric comprises chemical vapor infiltration of a matrix into said fabric.

**5.** A method according to any one of claims 1 to 4, **characterized in that** densifying the fiber fabric comprises using a liquid technique to infiltrate a matrix into said fabric.

**6.** A method according to claim 4 or claim 5, **characterized in that** the matrix is a ceramic matrix selected from at least: an oxide; a nitride; a carbide; and a silicide.

**7.** A method according to claim 6, **characterized in that** the ceramic matrix comprises at least silicon carbide and boron or a boron compound.

**8.** A method according to any one of claims 1 to 7, **characterized in that** it further comprises a step of shaping and consolidating the fiber fabric, which step is performed after the step of treating the fabric with a fluid under pressure and before the step of densifying said fabric.

FIG.1

EP 2 839 066 B1

FIG.2

FIG.3

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2952052
- US 5217796 A
- US 7101154 B
- US 7241112 B
- WO 2010061140 A
- WO 2006136755 A
- US 4752503 A
- US 5486379 A